Europäisches Patentamt

European Patent Office

Office européen des brevets

(11) Numéro de publication: **0 376 782**

**A1**

## (12) DEMANDE DE BREVET EUROPEEN

(21) Numéro de dépôt: 89403437.0

(22) Date de dépôt: 12.12.89

(51) Int. Cl.⁵: **G01R 31/02**

(30) Priorité: 20.12.88 FR 8816809

(43) Date de publication de la demande:
04.07.90 Bulletin 90/27

(84) Etats contractants désignés:
DE FR GB NL

(71) Demandeur: **COMPAGNIE EUROPEENNE DE COMPOSANTS ELECTRONIQUES LCC**
**50, rue Jean-Pierre Timbaud**
**F-92400 Courbevoie(FR)**

(72) Inventeur: **Clemencet, François**
**THOMSON-CSF SCPI Cédex 67**
**F-92045 Paris la Défense(FR)**
Inventeur: **Reamot, Hervé**
**THOMSON-CSF SCPI Cédex 67**
**F-92045 Paris la Défense(FR)**

(74) Mandataire: **Guérin, Michel et al**
**THOMSON-CSF SCPI**
**F-92045 PARIS LA DEFENSE CEDEX 67(FR)**

(54) **Dispositif de mesure d'une grandeur électrique de composants électroniques du type chips.**

(57) Dispositif automatique de mesure d'une grandeur électrique de composants chips, par exemple de la résistance d'isolement de condensateurs chips (3).

Une roue distributrice à alvéoles (2) alimente un à un une roue de mesure (3), qui est une roue à alvéoles du même type. La mesure s'effectue sur un angle α et est captée et amplifiée par un appareillage de mesure embarqué (14). Elle est ensuite transmise à un ordinateur (19) au moyen d'un collecteur rotatif (15 - 18). Les composants chips sont ensuite évacués par une troisième roue à alvéoles (4).

Fig.1

# DISPOSITIF DE MESURE D'UNE GRANDEUR ELECTRIQUE DE COMPOSANTS ELECTRONIQUES DU TYPE CHIPS

La présente invention se rapporte à un dispositif de mesure d'une grandeur électrique de composants électroniques du type chips, c'est-à-dire de composants de forme parallélépipédique destinés à être montés en surface sur un circuit imprimé, et comportant de ce fait des terminaisons soudables intégrées au parallélépipède.

La mesure d'une grandeur électrique des composants chips, en particulier celle de la résistance d'isolement des condensateurs chips, s'effectue classiquement sur des montages fixes, et consiste, par exemple dans le cas de la mesure de la résistance d'isolement d'un condensateur, à mesurer, à l'aide d'une mesure d'intensité ou d'une mesure de tension, le courant de charge du condensateur en régime établi, c'est-à-dire le courant résiduel lorsque le condensateur a pratiquement acquis sa pleine charge. Ces dispositifs classiques ont pour inconvénient de ne pas permettre d'effectuer une mesure, par exemple une mesure de résistance d'isolement sur un lot de condensateurs, à une cadence suffisamment élevée pour être par exemple compatible avec une chaîne industrielle de contrôle de composants chips, où la cadence actuellement souhaitée pour les mesures de vérification de ces composants en sortie de leur chaîne de fabrication est souvent de l'ordre de dix pièces par seconde.

L'invention vise à remédier à cet inconvénient. Elle se rapporte à cet effet à un dispositif automatique de mesure d'une grandeur électrique de composants du type chips (par exemple de la résistance d'isolement de condensateurs chips) qui utilise, pour effectuer cette mesure en continu, une roue rotative distributrice de composants chips, d'un type connu en soi et comportant des alvéoles réceptrices régulièrement réparties sur sa circonférence périphérique externe. Chacune de ces alvéoles extérieures est apte à recevoir un composant chips avec son axe longitudinal, c'est-à-dire l'axe perpendiculaire aux deux surfaces opposées du parallélépipède qui contiennent chacune une des deux terminaisons soudables du composant, parallèle à l'axe de rotation de la roue. Des moyens d'aspiration/soufflage, toujours connus en soi, sont prévus pour maintenir chaque composant chips dans son alvéole sur un angle de rotation déterminé de la roue, puis pour l'en éjecter en un point déterminé de la circonférence sur laquelle s'effectue cette rotation. D'autres moyens constités par exemple par deux autres roues à alvéoles de même type, sont en outre prévus d'une part pour approvisionner en continu et un à un cette roue distributrice en composants chips en un premier point déterminé de son trajet circonférentiel, et d'autre part pour les évacuer ensuite un à un en un deuxième point déterminé situé plus en aval sur ce trajet circonférentiel. Des paires de pinces de mesure, dont une paire par alvéole, sont solidaires de cette roue distributrice, et sont aptes chacune à être maintenues en contact avec les deux terminaisons soudables du composant chips respectif pendant au moins une partie du trajet circonférentiel de la roue distributrice entre les deux points prédéterminés précités. Ces pinces de mesure sont reliées à un appareillage de mesure qui est solidaire en rotation de la roue distributrice, et qui est de ce fait fixe en position angulaire relative par rapport à l'ensemble de pinces de mesure précitées.

Avantageusement, les signaux de sortie de cet appareillage de mesure embarqué sont transmis à un appareil de traitement de ces signaux, au moyen de connexions électriques rotatives du genre collecteur tournant.

De toute façon, l'invention sera bien comprise, et ses avantages et autres caractéristiques ressortiront, au cours de la description suivante d'un exemple non limitatif de réalisation appliqué à la mesure de la résistance d'isolement de condensateurs chips, en référence au dessin schématique annexé dans lequel :

- Figure 1 est une vue d'ensemble très simplifiée, en perspective latérale, de ce dispositif automatique de mesure de la résistance d'isolement d'une série de condensateurs chips ;

- Figure 2 est une vue de détail agrandie de deux alvéoles successives d'une roue distributrice utilisée dans ce même dispositif ;

- Figure 3 est une partielle, en coupe verticale longitudinale, de la partie centrale du dispositif de la figure 1 ; et

- Figure 4 est un schéma électrique permettant d'expliquer la méthode de mesure qu'utilise ce dispositif.

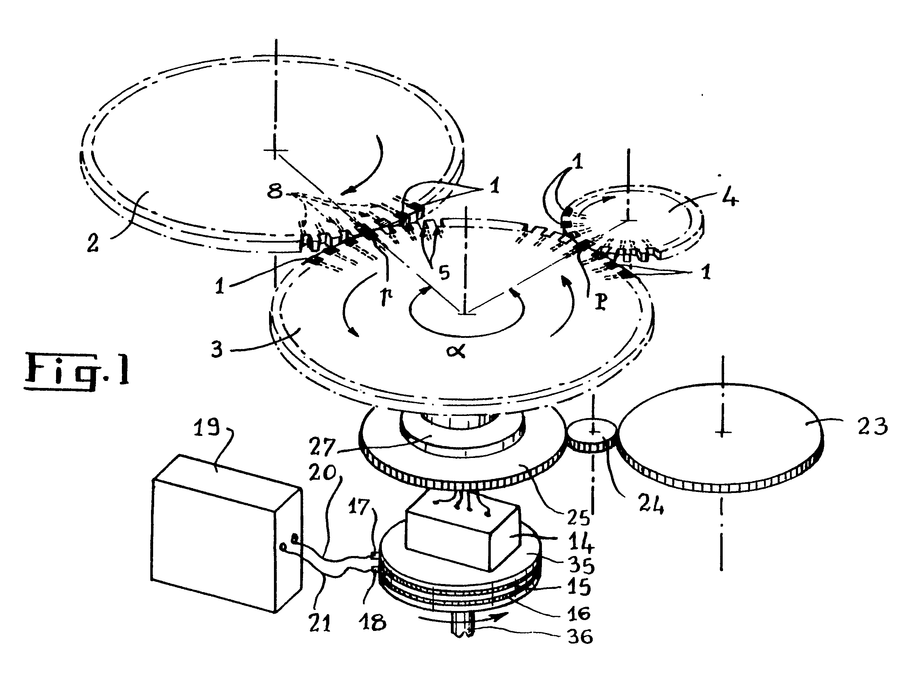

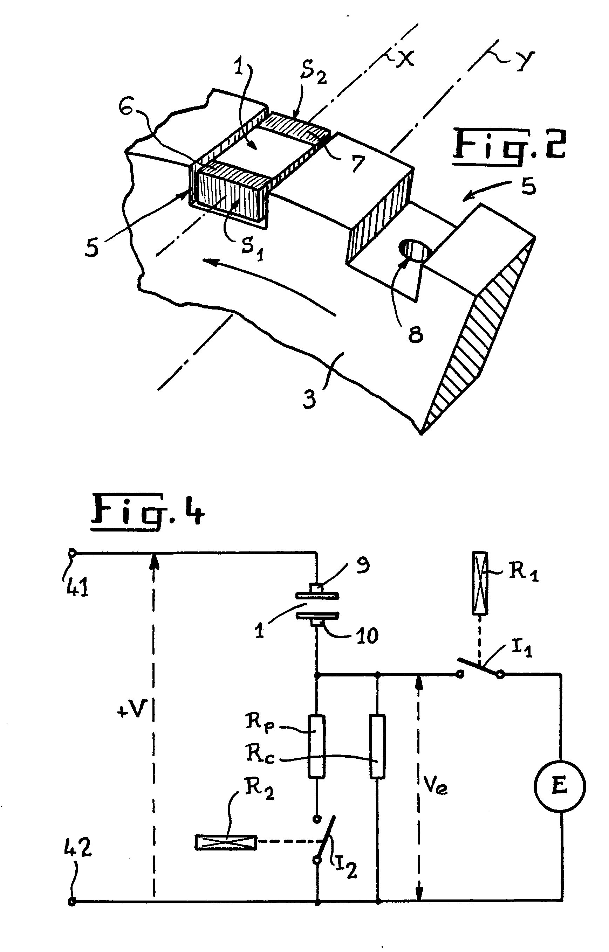

En se reportant tout d'abord à l'ensemble des figures 1 et 2, ce dispositif de mesure automatique de la résistance d'isolement de condensateurs chips 1 utilise trois roues rotatives distributrices 2, 3, 4, à alvéoles extérieures 5 régulièrement réparties sur leur circonférence périphérique extérieure.

De telles roues distributrices sont en soi bien connues. Leurs alvéoles 5 sont toutes identiques, et elles sont conformées pour recevoir chacune un composant chips 1 avec son axe longitudinal X parallèle à l'axe de rotation Y de la roue. Par "axe longitudinal", on entend l'axe X perpendiculaire aux deux surfaces opposées $S_1$, $S_2$ du parallélépipède 1 qui contiennent chacune une des deux terminaisons soudables 6, 7 du condensateur. Des canaux 8 d'aspiration/soufflage sont prévus dans le corps de la roue, et chacun d'eux débouche dans le fond d'une alvéole 5 (figure 2). Ils sont reliés à une source de vide sur un angle de rotation déterminé α du trajet circonférentiel de chaque roue commençant en p, et maintiennent alors chaque composant chips 1 dans son alvéole respective 5 par effet d'aspiration. Ils sont au contraire reliés à une source d'air pressurisé en un point déterminé P de ce trajet circonférentiel, situé au bout du trajet d'aspiration α , et ils entraînent alors l'éjection en ce point P de chaque composant chips 1 par effet de soufflage.

La roue 2 a simplement pour rôle d'approvisionner un à un les composants chips 1, sortant par exemple de leur chaîne de fabrication ou d'un poste de vérification en sortie de chaîne, de façon à les fournir un à un aux alvéoles successives de la roue 3, qui est la roue de mesure proprement dite. L'opération totale de mesure de la résistance d'isolement s'effectue sur l'angle de rotation α précité, puis les condensateurs 1 sont transférés, au point P, sur la roue d'évacuation 4.

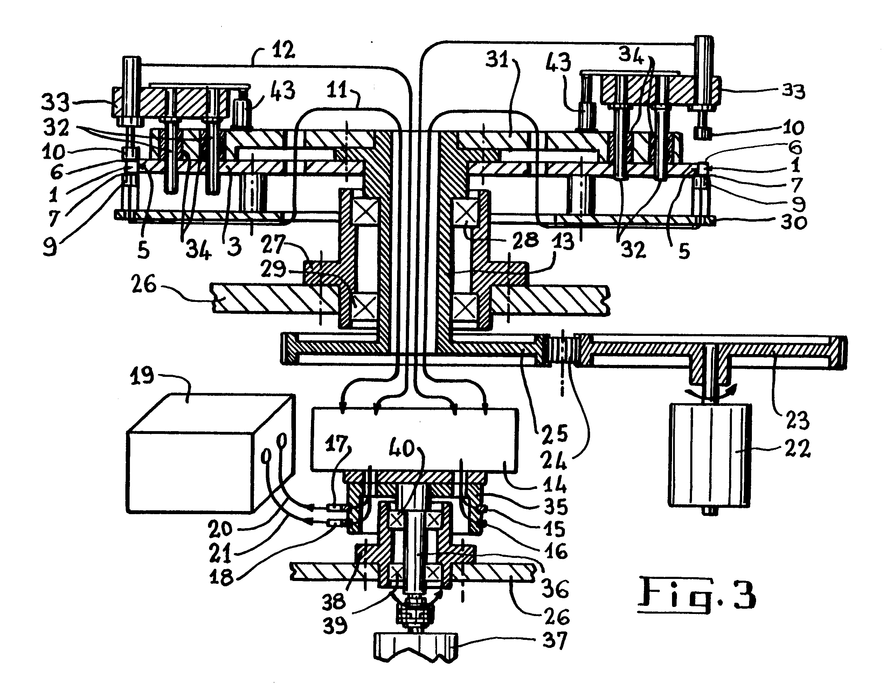

En se reportant également à la figure 3, la mesure de la résistance d'isolement RI s'effectue, pour chaque condensateur 1, à l'aide de deux pinces de mesure, ou sondes, 10 et 9 qui viennent pendant la mesure s'appliquer respectivement contre les deux terminaisons soudables 6, 7 du condensateur.

Chaque paire de fils de connexion 11, 12 respectivement reliés aux pinces 9, 10, passe à travers l'arbre creux 13 qui supporte et entraîne en rotation la roue centrale de mesure 3, et cette paire de fils 11, 12 est reliée à un appareillage de mesure "embarqué" 14 qui est solidaire en rotation de la roue 3.

Cet appareillage de mesure 14 délivre, sur deux couronnes conductrices 15, 16 solidaires de cet appareil 14, formant collecteur tournant, des signaux successifs, amplifiés et mis en forme, qui sont représentatifs des résistances d'isolement RI des condensateurs 1 successifs. Ces signaux sont captés par deux balais fixes 17, 18, qui frottent respectivement sur les deux pistes 15 et 16, et ils sont transmis à un ordinateur 19 par les fils 20 et 21.

Sur la figure 3, le dispositif central, associé directement à la roue de mesure 3, est visible plus en détails que sur la figure 1.

L'arbre creux 13 précité est entraîné en rotation par un premier moteur électrique 22 et par une transmission mécanique par exemple à trois roues 23, 24, 25, la dernière roue 25 étant solidaire de cet arbre 13.

L'arbre 13 est supporté par le bâti 26 par l'intermédiaire d'un palier 27 contenant deux roulements à bille 28 et 29. La roue à alvéoles 3 est solidaire de deux plateaux horizontaux qui lui sont parallèles :
. un plateau inférieur annulaire 30 qui porte les pinces inférieures 9, dont une pince 9 par alvéole ;
. un plateau supérieur 31 qui sert d'organe de guidage et de support d'un autre plateau annulaire horizontal 33, mobile verticalement et portant les pinces inférieures 10, par alvéole.

Le guidage s'effectue au moyen de tiges verticales coulissantes 32, solidaires de ce plateau mobile 33, et il est facilité par des coussinets tubulaires 34.

Le plateau 33 est déplaçable verticalement sous l'effet de vérins électriques de support 43, fixés au plateau fixe 31, entre deux positions extrêmes, dont une position "haute", représentée sur la droite de la figure 3, et pour laquelle la pince 10 n'est pas en contact avec le condensateur associé 1, et une position "basse", représentée sur la gauche de la figure 3, et pour laquelle la pince 10 est en contact avec son condensateur 1. De ce fait, si les fils 11 peuvent être totalement rigides, puisqu'ils ne subissent aucune déformation, en revanche, les fils 12 doivent être souples, ou pour le moins semi-rigides, puisqu'ils doivent accompagner les pinces 10 correspondantes dans leur déplacement vertical d'ouverture et de fermeture.

L'appareillage de mesure 14 est porté par un tambour 35, sur la périphérie duquel sont fixées les pistes conductrices 15, 16 précitées, et ce tambour 35 est lui-même porté par un arbre vertical 36 qui est entraîné en rotation par un deuxième moteur électrique 37. Ce moteur électrique 37 est synchronisé en rotation avec le moteur 22, par des moyens électriques classiques non représentés, de façon que les arbres 36 et 13 tournent dans le même sens et rigoureusement à la même vitesse.

L'arbre 36 est porté par le bâti 26 par l'intermédiaire d'un palier 38 qui contient deux roulements à bille 39 et 40.

La mesure de résistance d'isolement RI, qui s'effectue au cours de la rotation α précitée (figure 2) utilise une méthode, connue en soi, de mesure de tension aux bornes d'une résistance de charge, avec utilisation d'une résistance de précharge. Le schéma du circuit qui permet d'effectuer cette mesure est rappelé maintenant, en référence à la figure 4.

Le condensateur chips 1 est connecté, pendant le temps de mesure, c est-à-dire lorsqu'il est en contact avec les deux pinces de mesure 9, 10, aux deux bornes 41 et 42 d'une source de tension continue de valeur + V, à travers une résistance de charge Rc, déterminée pour que la constante de temps de charge

$$\tau = Rc \times C$$

du condensateur 1 de capacité C soit inférieure à une seconde.

Un électromètre E peut être branché, par la fermeture d'un contact rapide $l_1$ commandé par un relais $R_1$, aux bornes de cette résistance Rc.

Une résistance de précharge Rp, de valeur ohmique plus que dix fois inférieure à celle de la résistance de charge Rc, peut être branchée en parallèle sur Rc par la fermeture d'un autre contact $l_2$, commandé par un relais $R_2$.

En se référant également aux figures 1 et 3, le fonctionnement de la mesure de résistance d'isolement est le suivant:

Dès qu'un condensateur chips 1 est transféré de la roue 2 à la roue 3, c'est à dire au point p en début du trajet circonférentiel $\alpha$, les pinces 9 et 10 se referment sur ses deux connexions 6 et 7, en même temps que le relais $R_2$ entraine la fermeture de l'interrupteur $l_2$.

Cet interrupteur $l_2$ reste fermé pendant environ une seconde, ce qui correspond à une rotation de la roue 3 d'une portion de l'angle $\alpha$ , soit dans l'exemple représenté, à une rotation d'environ 48 degrés. Pendant tout ce temps, le condensateur 1 se charge essentiellement à travers la résistance Rp, et, au bout d'une seconde, la tension acquise à ses bornes est très peu inférieure à la valeur + V de la tension continue appliquée entre les bornes 41 et 42.

Le relais $R_2$ commande alors l'ouverture de l'interrupteur $l_2$, de sorte que seule la résistance Rc est placée en série avec le condensateur 1 pendant toute la valeur restante du trajet $\alpha$ , c'est-à-dire durant environ 4 secondes. Pendant ce temps, l'intensité du courant traversant le condensateur 1 acquiert progressivement sa valeur permanente en charge totale, valeur qui correspond à celle passant alors à travers la résistance d'isolement RI à mesurer.

Au point P, le relais $R_1$ entraine, pendant un laps de temps très bref, inférieur à 50 millisecondes, la fermeture de l'interrupteur $l_1$, de sorte que l'électromètre E mesure la tension Ve aux bornes de la résistance Rc, et transmet cette valeur de tension à l'appareillage de mesure 14 qui réalise son amplification et sa mise en forme. Cette dernière valeur de tension est transmise, par l'intermédiaire du collecteur tournant 15 - 18, à l'ordinateur central 19 qui en déduit la valeur de la résistance d'isolement RI par la formule :

$$RI = \frac{V - Ve}{Ve} \times Rc$$

Cette mesure étant effectuée, ce composant chips, se trouvant au point P, est transféré vers la roue 4 puis évacué par cette dernière.

Comme il va de soi, l'invention n'est pas limitée à l'exemple de réalisation qui vient d'être décrît. C'est ainsi que l'on ne sortirait pas de son cadre en remplaçant la synchronisation électrique des vitesses de rotation des arbres 13 et 36 par une synchronisation mécanique. L'ouverture et la fermeture des pinces 9 et 10 pourrait être déclenchée par un mécanisme à cames au lieu d'un mécanisme à vérins. La phase de précharge n'est pas toujours obligatoire et dépend plutôt de la valeur de la capacité du composant à tester. Bien entendu, l'invention ne s'applique pas seulement à la mesure de la résistance d'isolement de condensateurs chips : elle s'applique d'une manière plus générale à la mesure d'une grandeur électrique d'un composant chips.

## Revendications

1 - Dispositif de mesure automatique d'une grandeur électrique de composants électroniques du type chips (1) : caractérisé :
. en ce qu'il utilise, pour effectuer cette mesure en continu, une roue rotative (3) distributrice de composants chips (1), cette roue comportant des alvéoles récetrices (5) régulièrement réparties sur sa circonférence périphérique externe, chacune de ces alvéoles extérieures (5) étant apte à recevoir un composant chips (1) avec son axe longitudinal (X) parallèle à l'axe de rotation (Y) de la roue (3), et des moyens (8) d'aspiration/soufflage étant prévus pour maintenir chaque composant chipts (1) dans son alvéole (5) sur un angle de rotation déterminé ($\alpha$) de la roue (3), puis pour l'en éjecter en un point déterminé (P) de la circonférence sur laquelle s'effectue cette rotation ;
. en ce qu'il comporte des moyens (2, 4) d'une part pour approvisionner en continu, et un à un, cette roue distributrice (3) en composants chips (1) en un premier point déterminé (p) de son trajet circonférentiel, et d'autre part pour les en évacuer ensuite un à un en un deuxième point prédéterminé (P) situé plus en aval sur ce trajet circonférentiel ;
. en ce que des paires de pinces de mesure (10, 9), dont une paire par alvéole (5), sont solidaires de cette roue distributrice (3), et sont chacune aptes à être maintenues en contact avec les deux terminaisons soudables (6, 7) du composant chips respectif (1) pendant au moins une partie du trajet circonférentiel ($\alpha$) de la roue distributrice (3) entre les deux points prédéterminés (p, P) précités ;
. et en ce que ces pinces de mesure (9, 10) sont reliées à un appareillage de mesure embarqué (14) qui est solidaire en rotation de la roue distributrice (3).

2 - Dispositif de mesure automatique d'une grandeur électrique de composants chips selon la revendication 1, caractérisé en ce que les signaux de sortie de cet appareillage de mesure embarqué (14) sont transmis à un appareil de traitement (19) de ces signaux au moyen de connexions électriques rotatives (15 - 18) du genre collecteur tournant.

3 - Dispositif de mesure automatique de la résistance d'isolement de condensateurs chips selon la revendication 2, caractérisé en ce que cet appareillage de mesure (14) effectue l'amplification des tensions en charge permanente (Ve) mesurées au moyen des pinces (9, 10) aux bornes des condensateurs (1), et en ce que le calcul de la résistance d'isolement (RI) qui en découle est effectué par cet appareil de traitement (19).

4 - Dispositif de mesure automatique de la résistance d'isolement de condensateurs chips selon l'une des revendications 1 à 3, caractérisé en ce qu'il utilise une résistance de précharge (Rp) pour effectuer au cours du trajet ($\alpha$) entre ces deux points préterminés (p, P), tout d'abord une charge rapide du condensateur (1), cette résistance (Rp) étant de ce fait mise en parallèle sur la résistance de charge (Rc) du condensateur sur une première partie de ce trajet ($\alpha$), puis déconnectée pour laisser un régime permanent s'établir sur le restant de ce trajet ($\alpha$) afin d'effectuer la mesure de la tension (Ve) aux bornes de la résistance de charge (Rc), en régime permanent.

5 - Dispositif de mesure selon l'une des renvendications 1 à 4, caractérisé en ce que la prise du signal (Ve) apte à permettre le calcul de la grandeur électrique (RI) est effectuée au deuxième point prédéterminé (P).

6 - Dispositif de mesure selon l'une des revendications 1 à 5, caractérisé en ce que la fermeture des pinces de mesure (9, 10) est effectuée au premier point prédéterminé (p).

7 - Dispositif de mesure selon l'une des revendications 1 à 6, caractérisé en ce que les moyens d'approvisionnement de la roue distributrice (3) en composants chips (1) sont constitués par une roue à alvéoles (2) de même type.

8 - Dispositif de mesure selon l'une des revendications 1 à 7, caractérisé en ce que les moyens d'évacuation un à un des composants chips (1) de cette roue distributrice (3) sont constitués par une roue à alvéoles (4) de même type.

9 - Dispositif de mesure selon l'une des revendications 1 à 8, caractérisé en ce que les moyens d'entraînement en rotation (22, 37) de la roue distributrice (3) d'une part, et du dispositif de support (35) de l'appareillage de mesure embarqué (14) d'autre part, sont des moyens distincts (22 et 37) mais synchronisés en rotation de façon que cette roue (3) et ce dispositif de support (35) tournent dans le même sens et à la même vitesse.

Fig.1

EP 0 376 782 A1

**Fig.2**

**Fig.4**

Fig.3

## DOCUMENTS CONSIDERES COMME PERTINENTS

| Catégorie | Citation du document avec indication, en cas de besoin, des parties pertinentes | Revendication concernée | CLASSEMENT DE LA DEMANDE (Int. Cl.5) |
|---|---|---|---|
| A | US-A-3 761 806 (NAPOR et al.)<br>* Résumé; figures 1-5 *<br>--- | 1-2 | G 01 R 31/02 |
| P,A | US-A-4 795 966 (COOK)<br>* Résumé; figure 1 *<br>--- | 4 | |
| A | DE-A-2 820 404 (SIEMENS A.G.)<br>--- | | |
| A | US-A-2 567 741 (WESTERN ELECTRIC)<br>----- | | |

DOMAINES TECHNIQUES
RECHERCHES (Int. Cl.5)

G 01 R 31/00

Le présent rapport a été établi pour toutes les revendications

| Lieu de la recherche | Date d'achèvement de la recherche | Examinateur |
|---|---|---|
| LA HAYE | 26-03-1990 | TRELEVEN C. |

EPO FORM 1503 03.82 (P0402)